**Europäisches Patentamt**

(19) **European Patent Office**

**Office européen des brevets**

(11) Veröffentlichungsnummer: **0 002 040**
B1

(12) # EUROPÄISCHE PATENTSCHRIFT

(45) Veröffentlichungstag der Patentschrift:
30.12.81

(51) Int. Cl.³: **G 03 F 7/16**, B 05 C 5/00,
H 05 K 3/34, B 23 K 37/06

(21) Anmeldenummer: **78101347.9**

(22) Anmeldetag: **11.11.78**

(54) **Verfahren zur Herstellung von Lötstoppmasken auf gedruckten Schaltungen mit Druckkontaktierungsbohrungen.**

(30) Priorität: **21.11.77 CH 14182/77**

(43) Veröffentlichungstag der Anmeldung:
**30.05.79 Patentblatt 79/11**

(45) Bekanntmachung des Hinweises auf die Patenterteilung:
**30.12.81 Patentblatt 81/52**

(84) Benannte Vertragsstaaten:
**BE CH DE FR GB NL SE**

(56) Entgegenhaltungen:
**DE-A-1 772 976**
**DE-A-2 541 280**
**DE-B-1 089 307**
**FR-A-1 227 231**
**FR-A-1 556 137**
**FR-A-2 272 415**
**US-A-2 963 002**
**US-A-3 132 968**
**US-A-3 205 089**
**US-A-3 500 610**
**US-A-3 876 465**

(73) Patentinhaber: **CIBA-GEIGY AG, Patentabteilung
Postfach, CH-4002 Basel (CH)**

(72) Erfinder: **Losert, Ewald, Habsburgerstrasse 30,
CH-4310 Rheinfelden (CH)**
Erfinder: **Rembold, Heinz, Dr., Hollenweg 39,
CH-4144 Arlesheim (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Verfahren zur Herstellung von Lötstoppmasken auf gedruckten Schaltungen mit Durchkontaktierungsbohrungen

Bei der Herstellung durchkontaktierter, gedruckter Schaltungen gehen immer mehr Hersteller dazu über, vor dem Lötprozess eine Lötstoppmaske auf die Schaltung aufzubringen. Diese Lötstoppmasken haben die Aufgabe, alle Stellen der Schaltungsoberfläche, die nicht mit dem Lötmetall in Kontakt treten sollen, beim Lötprozess zu schützen und damit unerwünschte leitende Brücken zwischen den Leiterzügen zu vermeiden. Diese Lacke sollen aber gleichzeitig auch die Funktion einer Isolationsschicht, besonders gegen Verschmutzung und Feuchtigkeit, für die fertige Schaltung übernehmen. Um diese beiden Forderungen zufriedenstellend zu erfüllen, wurden die verschiedensten Produkte und Verfahren entwickelt. Da überall dort, wo das Lötmetall aufgebracht werden sollte, etwa in den durchkontaktierten Bohrlöchern und den Lötaugen oder auch an Stellen, in denen die Schaltung mit andern Elementen weiter durchkontaktiert werden soll, kein Lötstopplack vorhanden sein darf, muss die Lötstoppmaske eine bestimmte vorgegebene Bildstruktur aufweisen. Naheliegend war es deshalb, Druckverfahren zur Aufbringen dieses Maskenbildes heranzuziehen. Da der Lack eine gewisse Schichtdicke aufweisen muss, um die oben erwähnten Funktionen zufriedenstellend zu gewährleisten und ausserdem die Leiterzüge gut einbetten soll, hat sich das Siebdruckverfahren zur Erzeugung von Lötstoppmasken in der Praxis bewährt. Mit diesem Verfahren lässt sich rasch eine für eine Massenproduktion entsprechend reproduzierbare Lötstoppmaske aufbringen. Als Lacke werden für die höheren Qualitäten Zweikomponentensysteme auf Basis von Epoxidharzen und neuerdings auch lösungsmittelfreie UV-härtende Harze auf Basis von Acrylaten verwendet. Der Nachteil dieser Technik besteht darin, dass — bedingt durch die Siebdrucktechnik — nur eine bestimmte Bildfeinheit erzeugt werden kann. Nachteilig ist ausserdem bei kleineren Schaltungsserien oder Prototypen die aufwendige Herstellung der Drucksiebe.

Seit der Einführung der sog. Feinleitertechnik, die darin besteht, sehr viele und feine Leiterzüge in sehr geringen Leiterzugsabständen auf eine Schaltung unterzubringen, ist die Siebdruckmethode zur Erzeugung der notwendigen Feinheit des Maskenbildes in vielen Fällen unzureichend. Dieser Effekt wird noch dadurch zusätzlich ungünstig beeinflusst, dass die verwendeten Drucktinten nach dem Druckvorgang, bzw. beim Trocknen noch nachfliessen. Dadurch ist man gezwungen, auf dem Drucksieb die Abdeckung für die Bohrlöcher grösser zu dimensionieren als dies eigentlich wünschenswert wäre. Ausserdem macht sich beim Bedrucken grösserer Flächen, bzw. grösserer Schaltungsformate ein Verzug des Drucksiebes fehlererzeugend dahingehend bemerkbar, dass ein Druckversatz entsteht.

Aus diesen Gründen hat man für die Feinleitertechnik nach besseren Verfahren zur Erzeugung eines Maskenbildes mit höherer Bildauflösung gesucht. Die Heranziehung von Photoverfahren unter Verwendung von UV-empfindlichen Photopolymeren war naheliegend.

Es wurden deshalb Verfahren gesucht, die es ermöglichen, Photopolymere mit einer geeigneten Technik zur Erzeugung von Lötstoppmasken heranzuziehen. Ein solches bekanntes Verfahren besteht z.B. darin, dass ein Photopolymerfilm (dünne Folie) zunächst durch einen speziellen Laminator (erhitzte Rolle) auf die Schaltungsoberfläche aufgepresst wird. Dieser Film wird durch ein Negativ abgedeckt, dann mit UV-Licht bestrahlt und schliesslich die unbelichteten Stellen nach der Entfernung des Negativs mit geeigneten Entwicklern herausgelöst. Hierdurch entsteht das Maskenbild, welches eine wesentlich feinere Bildstruktur aufweist, als die im Siebdruckverfahren erzeugten Masken. Die Nachteile dieses Filmverfahrens bestehen darin, dass es einer aufwendigen Technologie bedarf, um die Lötstoppfilme gut haftend und luftfrei auf die Oberfläche der gedruckten Schaltung aufzubringen. Bleiben nur geringste Spuren von Feuchtigkeit, Luft oder aber auch andere staubförmige Verunreinigungen zwischen dem Film und der Schaltung, so zeigen sich beim späteren Lötprozess Blasen und Ablösungserscheinungen der Lötstoppmaske, die schwerwiegende Folgen nach sich ziehen können.

Mit diesem Filmkaschierprozess verbundene Schwierigkeiten und Nachteile treten naturgemäss bei der Verwendung von flüssigen Lacken nicht auf. Diese erzeugen bei genügendem Fluss eine einwandfreie, hohlraumfreie Oberfläche, wodurch Lufteinschlüsse vermieden werden. Doch ist es bislang nicht gelungen, solche Lacke, die allen gestellten Eigenschaften wie gute Bildauflösung, hohe Haftung auf Metall und Kunstharzen, hohe thermische, mechanische und elektrische Eigenschaften nach Feuchtigkeitslagerung sowie hohe Chemikalienbeständigkeit aufweisen, in geeigneten Verfahren als Lötstoppmasken zu verwenden. Die Schwierigkeiten bestehen insbesondere darin, in möglichst wenig Arbeitsgängen die erforderliche Lackschicht blasenfrei und gleichmässig aufzubringen und dabei eine Verstopfung der durchkontaktierten Löcher zu vermeiden. Bringt man etwa solchen Lacke im roller coating, durch Tauchbeschichten oder aber auch im Siebdruckverfahren mit Leersieben auf die Schaltung auf, so entsteht meist ein Lackpfropfen in den Löchern, welcher nicht mehr durch den späteren Entwicklungsprozess in genügender Weise entfernt werden kann. Man benötigt zum Freientwickeln der Bohrungen meist längere Entwicklungszeiten als diejenigen, die bei den gebräuchlichen Lacken zu einer einwandfreien Bilderzeugung notwendig sind. Dies hat wiederum den Nachteil, dass länger belichtet werden muss, damit der UV-gehärtete Lack während dieser Entwicklungszeit stabil bleibt, was wiederum zu weniger guter Bildauflösung führt. Es gelingt zwar durch Sprühverfahren bei Berücksichtigung verschiedener Parameter wie Abstand der Sprühdüse, Sprühwinkel, Sprühdruck etc. Schaltungen so zu beschichten, dass die Löcher frei entwicklet werden können, doch ist es nach diesem Verfahren sehr schwierig, gleichmässige Schichtdicken zu erzeugen. Auch ist durch Erzeugung von Lösungsmitteldämpfen im Sprühverfahren ein höherer Aufwand für Schutzvorrichtungen zur Gewährleistung der betriebshygienischen Vorschriften notwendig.

Die Erfindung betrifft ein Verfahren zur Herstellung von Lötstoppmasken auf gedruckten Schaltungen mit Durchkontaktierungsbohrungen, bei welchem in aufeinanderfolgenden Schritten eine durch Bestrahlung mit insbesondere UV-Licht härtbare flüssige Substanz (Photopolymer) als dünne Schicht auf die gedruckte Schaltung aufgebracht und diese Schicht unter Aussparung der Lötstellen bildmässig bestrahlt und anschliessend mit einem die nicht bestrahlten Bereiche lösenden Mittel entwickelt wird.

Durch die Erfindung soll ein Verfahren zur flüssigen Aufbringung von Lötstoppmasken geschaffen werden, welches es ermöglicht, bereits durchkontaktierte Schaltungen so zu beschichten, dass bei der Beschichtung der Schaltung die Löcher derselben harzfrei bleiben oder nur einen so dünnen Harzfilm erhalten, dass beim Entwickeln eine völlige Entfernung des Harzes im Lochbereich gewährleistet ist.

Überraschenderweise wurde gefunden, dass die gestellte Aufgabe durch Anwendung des an sich bekannten Vorhanggussverfahrens durch besondere Wahl der Verfahrensparameter, insbesondere der Viskosität der Giessmasse, der Vorhanghöhe und der Geschwindigkeit der durch den Vorhang laufenden gedruckten Schaltungen gelöst werden kann.

Demgemäss ist die Erfindung dadurch gekennzeichnet, dass die flüssige Substanz mittels eines fliessenden Vorhandes auf die durch diesen Vorhang transportierten gedruckten Schaltungen appliziert wird, wobei erstens die Viskosität der flüssigen Substanz so eingestellt wird, dass sie beim Auftreffen auf die gedruckten Schaltungen 500-1200 mPa/s (Millipascal—Sekunden), vorzugsweise 600-900 mPa/s beträgt, zweitens die Vorhanghöhe so gewählt wird, dass die Fliessgeschwindigkeit des Vorhanges beim Auftreffen auf die gedruckten Schaltungen etwa 60 bis 160 m/min, vorzugsweise 70-120 m/min beträgt, und drittens die Transportgeschwindigkeit der gedruckten Schaltungen zumindest angenähert gleich oder grösser als die Endgeschwindigkeit des Vorhanges gewählt wird.

Gegen die Anwendung des Vorhanggiessverfahrens zum direkten Beschichten von Leiterplatten mit Durchkontaktierungsbohrungen bestanden bislang beträchtliche Vorurteile.

Im folgenden wird die Erfindung anhand der Zeichnungen näher erläutert, es zeigen:

Fig. 1 eine Giessmaschine zur Durchführung des neuen Verfahrens in schematischer Darstellung;

Fig. 2a-2d die wichtigsten Phasen einer ersten Verfahrensvariante;

Fig. 3a-3d die wichtigsten Phasen einer zweiten Verfahrensvariante.

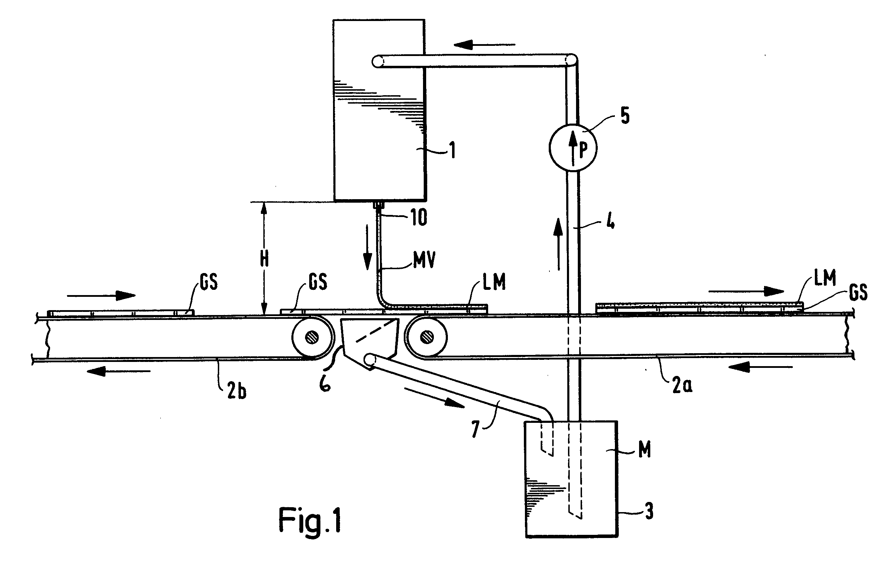

Die in Fig. 1 dargestellte Giessmaschine umfasst einen Giesskopf 1 mit einem Giessschlitz 10, eine Transportvorrichtung mit zwei Förderbändern 2a und 2b, ein Vorratsgefäss 3, eine Speiseleitung 4, eine Förderpumpe 5, eine Auffangrinne 6 und eine Rücklaufleitung 7. Der Abstand H zwischen dem Giesskopf 1 und den Förderbändern 2a und 2b ist vorzugsweise durch Verstellung des Giesskopfes höhenverstellbar. Desgleichen sind die Spaltweite des Giessschlitzes 10, die Förderleistung der Pumpe 5 und die Geschwindigkeit der Förderbänder bzw. des diese austreibenden Motors (nicht dargestellt) in weiten Bereichen regelbar.

Die zu beschichtenden gedruckten Schaltungen sind mit GS bezeichnet und werden auf Förderbändern 2a-2b unter dem Giesskopf 1 hindurchtransportiert. Dabei fällt die aus dem Schlitz 10 austretende Giessharzmasse M in Form eines im wesentlichen frei fallenden Vorhanges MV auf die Platten GS und bildet dort einen dünnen Überzug LM. Da die Platten GS verglichen mit der Vorhanghöhe sehr dünn sind, ist der Abstand zwischen dem Giesskopf 1 und den Platten praktisch gleich gross wie der Abstand H zwischen dem Giesskopf und den Förderbändern 2a-2b.

Beispielsweise ist in der US-Patentschrift Nr. 4 018 940 streng unterschieden zwischen der Herstellung von Ätzmasken auf nichtgelochten und Lötstoppmasken auf gelochten Platten. Bereits in der Einleitung der US-Patentschrift (Spalte 1, Zeilen 42 bis 45) ist auf die Verstopfungsgefahr der Durchkontaktierungsbohrungen ausdrücklich hingewiesen. Dies findet dann seinen Niederschlag darin, dass gemäss der Lehre dieser Patentschrift nur auf nichtgelochten Platten der Photoresist direkt in flüssiger Form appliziert wird, wogegen bei gelochten Platten stets zuerst in einem separaten Arbeitsgang der Photoresist auf eine Trägerfolie, z.B. einen Mylar-Film appliziert und erst dieser beschichtete Film nach seiner Trocknung auf die Platte laminiert wird.

Der zeitraubende und aufwendige Umweg der separaten Filmherstellung und Laminierung wurde gewählt, obwohl dem Erfinder der Vorhangguss vertraut war, was z.B. daraus hervorgeht, dass in der US-Patentschrift zur Herstellung des Mylar-Films die Anwendung des Vorhanggusses vorgeschlagen wird (Spalte 14, Zeilen 6 bis 15) und obwohl Laminierverfahren naturgemäss gegenüber Nassbeschichtungsverfahren verschieden weitere Nachteile aufweisen, von denen einige bereits weiter oben erwähnt sind.

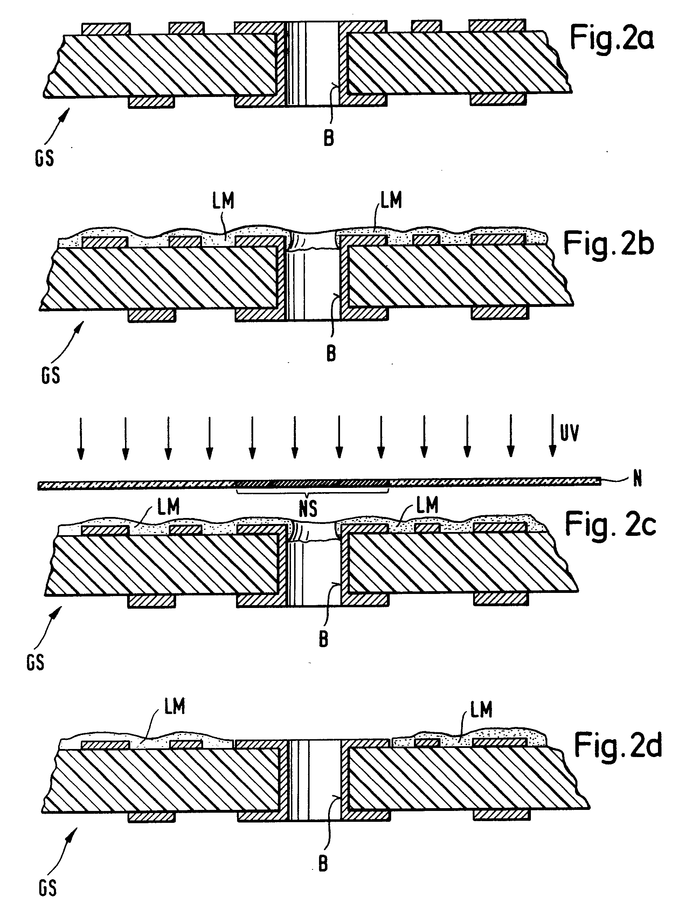

Wie das folgende Beispiel und die Fig. 2a-2c zeigen, können die Parameter Viskosität, Vorhanghöhe und Transportgeschwindigkeit so abgestimmt werden, dass der Überzug LM zu einer idealen Lötstoppmaske entwickelbar ist. Für die im folgenden beschriebene Herstellung einer Lötstoppmaske wurde eine Lackgiessmaschine der in Fig. 1 dargestellten Art von der Firma Bürkle & Co., Maschinenfabrik, Freudenstadt, Deutschland, mit der Modellbezeichnung LZKL 400 verwendet.

Die Lötstoppmaske wurde im einzelnen wie folgt hergestellt:

Bei einer Raumtemperatur von ca. 25°C wurde in die Giessmaschine (Vorratsgefäss 3) die folgende ca. 39%ige Polymerlösung eingefüllt, die bei Raumtemperatur eine Viskosität von ca. 750 mPa/s aufweist.

1500 g eines lichtempfindlichen Epoxidharzes vom Molekulargewicht 2000 und einem Epoxidgehalt von 0,8-1,0 Eq/kg

48 g 2,6 Xylylbiguanid

1000 g 1-Acetoxy-2-äthoxyäthan

1300 g Äthylenglykolmonomethyläther

3 g Farbstoff

Bei einer Höhe (H) des Giesskopfes (1) von 100 mm und einer Spaltweite des Giessschlitzes (10) von 0,6 mm betrug die Fallgeschwindigkeit des Vorhanges an seinem unteren Ende ca. 70-90 m/min. Die Laufgeschwindigkeit der Förderbänder 2a-2b wurde auf 130 m/min eingestellt.

Die zu beschichtende Schaltungsplatte (GS) hatte das Format 210 × 300 mm und Bohrlöcher (B) von 0,8 mm Durchmesser. Nach der Beschichtung besass diese Platte einen Lackauftrag von 6,10 g. Nach der anschliessenden Trocknung von 60 min/80°C in einem ventillierten Trockenschrank betrug die Lackschichtdicke auf Leiterzügen von 2 mm Breite 20-22 μ. Die Bohrlöcher waren nur am oberen Rande mit einem dünnen Lackfilm überzogen. Die so überzogenen gedruckten Schaltungen wurden unter Auflage eines Negativfilms 30 s mit einer 5000-Watt Metallhalogenid-Ultraviolettlampe belichtet und anschliessend in einer Lösung von Cyclohexanon entwickelt.

Eine Inspektion der Bohrlöcher sowie des Lackmaskenbildes ergab eine einwandfreie Sauberkeit der Löcher sowie eine hohe Konturenschärfe.

Nach einer anschliessenden Härtung von 1 h/130°C wurde die mit der Lackmaske überzogenen gedruckte Schaltung über eine übliche Lötwelle bei 260°C geführt. Nach dieser Prozédur befand sich der Lack in einwandfreiem Zustand und waren die Bohrlöcher überall einwandfrei mit Lötzinn gefüllt.

Die Fig. 2a-2d zeigen einen Lochbereich der Schaltungsplatte GS in vergrösserter Schnittdarstellung in den wichtigsten Phasen und zwar: Fig. 2a vor der Beschichtung, Fig. 2b nach der Beschichtung, Fig. 2c bei der Belichtung und Fig. 2d nach der Entwicklung.

Aus Fig. 2b ist ersichtlich, dass die Bohrung B mit Ausnahme ihres oberen Randbereiches frei von Überzugsmasse ist.

Die Belichtung und dadurch bewirkte Härtung der Schicht LM erfolgt gemäss Fig. 2c unter Zwischenschaltung einer Negativmaske N mittels UV-Strahlen, die durch die Pfeile UV symbolisiert sind. Die unterhalb des UV-undurchlässigen (schwarzen) Bereichs NS der Negativmaske liegenden Teile der Schicht LM werden nicht gehärtet.

In der anschliessenden Entwicklung (nicht dargestellt) werden die nichtgehärteten Bereiche der Schicht LM entfernt. Die nach der Entwicklung verbleibenden Teile der Schicht LM bilden die Lötstoppmaske. Die fertig maskierte Platte ist in Fig. 2d gezeigt.

Die Beschichtung kann auch mit einer Harz/Härter-Mischung erfolgen, die gegenüber dem vorangehenden Beispiel einen höheren Festkörpergehalt aufweist und die zum Erreichen der optimalen Giessviskosität bei erhöhter Temperatur verarbeitet wird. Gegenüber dem vorangehenden Beispiel wird ausserdem der Abstand zwischen Giesskopf und Förderband vergrössert und die Vorschubgeschwindigkeit der Schaltungsplatte GS erhöht. Die Temperatur der Beschichtungsmasse wird vorzugsweise so eingestellt, dass sie beim Auftreffen auf die Platte G mindestens 20°C höher ist als diejenige der Platte. Dadurch wird der Erstarrungsvorgang auf der Platte stark beschleunigt. Mit diesen Modifikationen ist es möglich, in einem Beschichtungsvorgang einen dikkeren Lackfilm auf die Schaltung aufzutragen, der sich im getrockneten Zustand wie eine Haut über die durchkontaktierten Bohrlöcher spannt. Da nur wenig Harz in die Bohrlöcher einfliesst, ist es nach dem Belichtungsprozess möglich, die Lötstoppmaske einwandfrei zu entwickeln und dabei alle störenden Harzreste aus den Bohrlöchern zu entfernen.

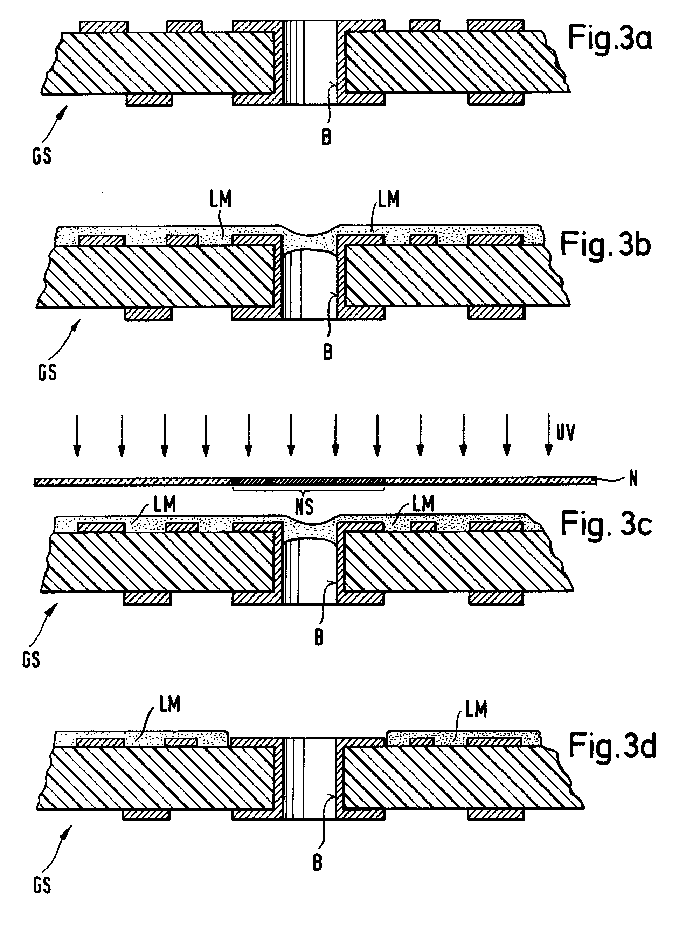

Die Fig. 3a bis 3d zeigen wiederum denselben Bereich der Platte GS während bzw. nach den wichtigsten Stufen des modifizierten Verfahrens: Fig. 3a vor der Beschichtung, Fig. 3b nach der Beschichtung, Fig. 3c bei der Belichtung und Fig. 3d nach der Entwicklung. Im Unterschied zu den Fig. 2b-2d zeigen die Fig. 3b-3d eine dickere Schicht LM und sind in den Fig. 3b und 3c die Bohrlöcher B nicht offen sondern mit einem dünnen Häutchen überzogen. Dieses Häutchen wird bei der Entwicklung (zwischen den Stufen 3c und 3d) aufgelöst und entfernt. In der aus Fig. 3d ersichtlichen Lötstoppmaske sind die Bohrlöcher wiederum absolut frei von Lötstopplack.

**Patentansprüche**

1. Verfahren zur Herstellung von Lötstoppmasken auf gedruckten Schaltungen mit Durchkontaktierungsbohrungen, bei welchem in aufeinanderfolgenden Schritten eine durch Bestrahlung mit insbesondere UV-Licht härtbare flüssige Substanz als dünne Schicht auf die gedruckte Schaltung aufgebracht, und diese Schicht unter Aussparung der Lötstellen bildmässig bestrahlt und anschliessend mit einem die nicht bestrahlten Bereiche lösenden Mittel entwickelt wird, dadurch gekennzeichnet, dass die flüssige Substanz mittels eines fliessenden Vorhanges auf die durch diesen Vorhang transportierten gedruckten Schaltungen appliziert wird, wobei erstens die Viskosität der flüssigen Substanz so eingestellt wird, dass sie beim Auftreffen auf die gedruckten Schaltungen 500-1200 mPa/s, vorzugsweise 600-900 mPa/s beträgt, zweitens die Vorhanghöhe so gewählt wird, dass die Fliessgeschwindigkeit des Vorhanges beim Auftreffen auf die gedruckten Schaltungen etwa 60 bis 160 m/min, vorzugsweise 70-120 m/min beträgt, und drittens die Transportgeschwindigkeit der gedruckten Schaltungen zumindest angenähert gleich oder grösser als die Endgeschwindigkeit des Vorhanges gewählt wird.

2. Verfahren gemäss Anspruch 1, dadurch gekennzeichnet, dass die flüssige Substanz so hoch erwärmt wird, dass sie mit einer Temperatur auf die gedruckte Schaltung auftrifft, die um mindestens 20°C über derjenigen der gedruckten Schaltung liegt.

## Claims

1. A process for producing solder masks on printed circuits with feedthrough boreholes, by applying, in successive steps, to a printed circuit a thin layer of a liquid substance which can be cured with ultraviolet light, irradiating said layer omitting the areas of the circuit to be soldered, and subsequently developing the layer with an agent which dissolves the non-irradiated areas, which process comprises applying the liquid substance by means of a free falling curtain to the printed circuit transported through said curtain such that, firstly, the viscosity of the liquid substance is adjusted to 500-1200 mPa/s, preferably 600-900 mPa/s, at impingement on said circuit, secondly, adjusting the height of said curtain such that the rate of flow of the curtain at impingement on the printed circuit is about 60 to 160 m/min, preferably 70 to 120 m/min, and, thirdly, adjusting the rate at which the printed circuit is transported through said curtain to a rate at least approximately the same as or greater than the terminal rate of the curtain.

2. A process according to claim 1, wherein the liquid substance is heated such that it impinges on the printed circuit at a temperature at least 20°C above the temperature of the printed circuit.

## Revendications

1. Procédé de fabrication de masques de soudage sur des circuits imprimés avec des trous de contact de traversée, selon lequel, dans des opérations successives, une substance fluide, durcissable par irradiation particulièrement avec de la lumière ultraviolette, est déposée sous la forme d'une mince couche sur le circuit imprimé, et cette couche est exposée sous la forme d'une image en épargnant les positions de soudage, et finalement développée avec un produit qui dissout les régions non exposées, procédé caractérisé en ce que la substance fluide est appliquée, au moyen d'un rideau en écoulement sur les circuits imprimés entraînés à travers ce rideau de manière que, premièrement, la viscosité de la substance fluide soit réglée pour atteindre une valeur de 500 à 1200 mPa/s, de préférence 600 à 900 mPa/s lorsqu'elle rencontre les circuits imprimés, que, deuxièmement, la hauteur du rideau soit choisie pour que la vitesse d'écoulement du rideau en rencontrant les circuits imprimés soit environ 60 à 160 m/min, de préférence 70 à 120 m/min, et, troisièmement, que la vitesse d'entraînement des circuits imprimés soit choisie au moins à peu près égale ou supérieure à la vitesse finale du rideau.

2. Procédé selon la revendication 1, caractérisé en ce que la substance fluide est chauffée suffisamment pour atteindre, lorsqu'elle rencontre le circuit imprimé, une température d'au moins 20°C supérieure à celle du circuit imprimé.

Fig.1

Fig.2a

Fig.2b

Fig. 2c

Fig.2d

**Fig.3a**

GS

B

**Fig.3b**

LM          LM

GS

B

↓ ↓ ↓ ↓ ↓ ↓ ↓ ↓ ↓ ↓ ↓ ↓ UV

N

NS

**Fig. 3c**

LM          LM

GS

B

**Fig.3d**

LM          LM

GS

B